# EUROPÄISCHE PATENTSCHRIFT

(11) **EP 2 041 771 B1**
(45) Veröffentlichungstag und Bekanntmachung des Hinweises auf die Patenterteilung: **01.02.2012**
(21) Anmeldenummer: 07726124.6
(22) Anmeldetag: 22.06.2007
(51) Int. Cl.: H01J 37/26

(54) **VERFAHREN UND VORRICHTUNG ZUR ERZEUGUNG EINES BILDES**
METHOD AND DEVICE FOR PRODUCING AN IMAGE
PROCÉDÉ ET DISPOSITIF DESTINÉS À PRODUIRE UNE IMAGE

(30) Priorität: 06.07.2006 DE 102006031643; 29.08.2006 DE 102006040308
(43) Veröffentlichungstag der Anmeldung: 01.04.2009
(73) Patentinhaber: Carl Zeiss NTS GmbH, 73447 Oberkochen (DE)
(72) Erfinder: SELLMAIR, Josef, 85356 Freising (DE)
(74) Vertreter: Tongbhoyai, Martin
(86) Internationale Anmeldenummer: PCT/EP2007/005498
(87) Internationale Veröffentlichungsnummer: WO 2008/003405

(56) Entgegenhaltungen:
- US-A- 4 990 778
- US-B1- 6 555 830

## Beschreibung

Die Erfindung betrifft ein Verfahren und eine Vorrichtung zur Erzeugung eines Bildes eines Objektes mittels eines Teilchenstrahls, wobei bei dem Verfahren bzw. in der Vorrichtung der Teilchenstrahl über das Objekt gerastert wird.

Die oben genannte Vorrichtung ist ein Teilchenstrahlsystem. Dieses kann beispielsweise als ein Elektronenstrahlsystem oder ein Ionenstrahlsystem ausgebildet sein. Die Verwendung insbesondere eines Elektronenstrahlsystems ist bereits sehr weit verbreitet. Ein Elektronenstrahlsystem wird beispielsweise zur Herstellung von Nano-Strukturen benutzt. Zu den Elektronenstrahlsystemen zählen auch die bereits seit langem bekannten Elektronenstrahlmikroskope, mit denen ein Bild eines Objektes erzeugt werden kann. Zu den beiden bekannten Elektronenstrahlmikroskopen zählen das Rasterelektronenmikroskop sowie das Transmissionselektronenmikroskop, wobei das Rasterelektronenmikroskop zur Erzeugung von hochauflösenden Bildern von Halbleiterstrukturen, biologischen und mineralogischen Proben sowie weiteren Proben verwendet wird.

Ein Elektronenstrahlsystem (auch Elektronenstrahlgerät genannt) wie das Rasterelektronenmikroskop weist einen Teilchenstrahlerzeuger in Form eines Elektronenstrahlerzeugers zur Erzeugung eines Elektronenstrahls, eine Objektivlinse zur Fokussierung des Elektronenstrahls auf einem Objekt und mindestens einen Detektor zur Detektion von am Objekt gestreuten oder vom Objekt emittierten Elektronen auf. Der durch den Teilchenstrahlerzeuger erzeugte Elektronenstrahl wird mittels der Objektivlinse auf das zu untersuchende Objekt fokussiert. Mittels einer Ablenkeinrichtung wird der Elektronenstrahl rasterförmig über die Oberfläche des zu untersuchenden Objektes geführt. Er wird also über die Oberfläche des Objektes gerastert. Die Elektronen des Elektronenstrahls treten dabei in Wechselwirkung mit dem Objekt. Als Folge der Wechselwirkung werden insbesondere Elektronen aus der Objektoberfläche emittiert (sogenannte Sekundärelektronen) oder Elektronen des Elektronenstrahls zurückgestreut (sogenannte Rückstreuelektronen). Sekundär- und Rückstreuelektronen können mit dem Detektor detektiert werden. Der Detektor erzeugt in Abhängigkeit der detektierten Sekundär- und Rückstreuelektronen ein Detektorsignal, welches zur Bilderzeugung verwendet wird.

Als Teilchenstrahlerzeuger (nachfolgend auch Teilchenstrahlquelle genannt) für Elektronen dienen beispielsweise thermische Feldemitter oder kalte Feldemitter. Die Verwendung derartiger Feldemitter ist bereits seit langem bekannt. In den letzten Jahren werden für verschiedenartige Anwendungen kalte Feldemitter eingesetzt, die miniaturisiert sind. So beschreibt die DE 103 02 794 A1 miniaturisierte Elektronenstrahlsysteme mit gleichfalls miniaturisierten kalten Feldemittern, die mittels Elektronenstrahl-induzierter Deposition hergestellt werden. Ferner ist aus der EP 1 186 079 B 1 eine miniaturisierte Elektronenstrahlquelle bekannt, die im Terahertzbereich arbeitet.

Kalte Feldemitter weisen einen hohen Richtstrahlwert und eine geringe Strahlenergiebreite auf. Sie eignen sich daher besonders gut, um sehr geringe Elektronenstrahldurchmesser zu erzielen, wodurch eine hohe Auflösung erzielt werden kann. Sie weisen jedoch den Nachteil auf, daß ihr Elektronenemissionsstrom zeitlich schwankt. Die zeitlichen Schwankungen im Elektronenemissionsstrom machen sich bei der Abbildung eines Objekts beispielsweise in einem Rasterelektronenmikroskop im Zeilenrasterbild als störende helle oder dunkle Streifen bemerkbar, was nicht erwünscht ist.

Der Erfindung liegt daher die Aufgabe zu Grunde, ein Verfahren und eine Vorrichtung zur Erzeugung eines Bildes eines Objektes mittels eines Teilchenstrahls anzugeben, welche mit einem kalten Feldemitter derart verwendbar sind, daß eine gute Bildqualität stets gewährleistet ist.

Diese Aufgabe wird erfindungsgemäß mit einem Verfahren mit den Merkmalen des Anspruchs 1 gelöst. Eine erfindungsgemäße Vorrichtung wird durch die Merkmale des Anspruchs 16 charakterisiert. Weitere Merkmale der Erfindung ergeben sich aus den weiteren Ansprüchen sowie aus der nachfolgenden Beschreibung.

Das erfindungsgemäße Verfahren zur Erzeugung eines Bildes eines Objektes mittels eines Teilchenstrahls erzeugt das Bild durch eine Rasterung des Teilchenstrahls über das Objekt. Zur Verbesserung der Bildqualität wird ein dem Teilchenstrahl zugeordneter Parameter bestimmt. Ferner wird festgestellt, ob sich der Parameter ändert. Sollte eine Änderung des Parameters aufgetreten sein, so wird der Ort am Objekt bestimmt, an dem die Änderung des Parameters aufgetreten ist. Anschließend wird der Teilchenstrahl an diesen Ort zurückgeführt. Es erfolgt ein erneutes Rastern des Teilchenstrahls über das Objekt von diesem Ort an.

Die Erfindung beruht auf der Erkenntnis, daß man die Eigenschaft eines Teilchenstrahlerzeugers, insbesondere eines kalten Feldemitters, ausschließlich sprunghafte Änderungen des Emissionsstromes zu zeigen und zwischen diesen sprunghaften Änderungen einen konstanten Emissionsstrom aufzuweisen, vorteilhaft für die Bilderzeugung nutzen kann. Der Emissionsstrom ändert sich bei Teilchenstrahlerzeugern in der Regel sprunghaft innerhalb sehr kurzer Zeit, meist kürzer als eine Mikrosekunde. Nach einer sprunghaften Änderung verbleibt der Emissionsstrom eine gewisse Zeit stabil, bevor es zu einem weiteren Sprung des Emissionsstroms kommt. Die Erfindung beruht nun darauf, bei Feststellung einer Änderung des Emissionsstroms zu reagieren und Maßnahmen für die Verbesserung der Bildqualität zu ergreifen. Bei Feststellung, daß der Emissionsstrom des Teilchenstrahlerzeugers sich ändert, wird sofort der Ort bestimmt, an dem die Änderung des Emissionsstroms stattgefunden hat. Der Teilchenstrahl wird an diesen Ort zurückgeführt, und es erfolgt ein erneutes Rastern des Teilchenstrahls über das Objekt von diesem Ort an aus. Die fehlerhafte Bildinformation, die man von bereits gerasterten Bildpunkten des Objekts erhalten hat, wird gelöscht und durch die Information ersetzt, die man aufgrund der wiederholten Rasterung erhält. Die Aufnahmezeit des Bildes erhöht sich durch eine erneute Rasterung nur unwesentlich.

Bei dem erfindungsgemäßen Verfahren wird vorzugsweise der Parameter nach Erkennung einer Änderung des Parameters auf einen Sollwert geändert. Beispielsweise wird bei Feststellung einer Änderung eines Emissionsstroms eines Emitters der Emissionsstrom auf einen Sollwert geändert, so daß stets eine ausreichend gute Bildgebung gewährleistet ist, insbesondere eine ausreichende und gute Helligkeit des Bildes.

Die Bestimmung des Ortes, an dem die Änderung des Parameters eintrat, erfolgt beispielsweise mittels einer Zeitberechung, vorzugsweise unter Berücksichtigung des Zeitpunkts des Feststellens der Änderung, der Geschwindigkeit des Rasterns des Teilchenstrahls und/oder Laufzeiten von Signalen.

Der Betrag der Änderung des Parameters, der eine Rückführung des Teilchenstrahls zur Folge hat, ist vorzugsweise einstellbar. Es ist somit ein Schwellenwert einstellbar. Dieses gewährleistet, daß nicht jede geringfügige Schwankung des Parameters zu einer Rückführung des Teilchenstrahls führt, sondern nur signifikante Änderungen.

Bei einer besonderen Ausführungsform des erfindungsgemäßen Verfahrens wird der Parameter über eine vorgegebene Zeit integriert und anschließend erst festgestellt, ob eine Änderung des Parameters aufgetreten ist. Diese Vorgehensweise ist insbesondere bei Beobachtung von Parametern vorteilhaft, deren Intensität nur gering ist. Um ein ausreichendes Signal mit einem hohen Signal-zu-Rausch-Verhältnis zu erhalten, erfolgt die Integration des Parameters über eine gewisse Zeit.

Bei einem weiteren Ausführungsbeispiel des erfindungsgemäßen Verfahrens wird der Teilchenstrahl jeweils von einem ersten Punkt eines vorgegebenen Musters bis zu einem zweiten Punkt des vorgegebenen Musters über das Objekt gerastert, wobei nach Feststellung einer Änderung des Parameters das Rückführen des Teilchenstrahls an den Ort der Änderung des Parameters erst dann erfolgt, wenn der Teilchenstrahl beim Rastern den zweiten Punkt des vorgegebenen Musters erreicht. Somit sieht dieses Ausführungsbeispiel es vor, daß eine erneute Rasterung des Teilchenstrahls über das Objekt erst erfolgt, nachdem das vorgegebene Muster zwischen zwei Punkten gerastert bzw. "abgerastert" wurde. Vorzugsweise ist der erste Punkt der Anfang des vorgegebenen Musters, und der zweite Punkt ist als das Ende des vorgegebenen Musters ausgebildet.

Das vorgegebene Muster ist beispielsweise eine Zeile (Bildzeile) oder eine Spalte (Bildspalte). Die Korrektur erfolgt dann nach Abrasterung dieser einen Zeile bzw. Spalte. Alternativ ist vorgesehen, daß als Muster mehrere aufeinander folgende Zeilen bzw. Spalten verwendet werden. Die Erfindung ist allerdings nicht auf ein zeilenförmiges oder spaltenförmiges Muster eingeschränkt. Vielmehr ist jegliches Muster verwendbar, welches für eine Rasterung verwendet werden kann, also eine Erfassung von Daten von Punkt zu Punkt auf einem Objekt.

Bei einer besonderen Ausführungsform des erfindungsgemäßen Verfahrens wird als Parameter ein Strom des Teilchenstrahls (auch Teilchenstrahlstrom oder Teilchenstrom genannt) bestimmt. Beispielsweise ist der Teilchenstrahlstrom der Emissionsstrom von Elektronen eines kalten Feldemitters.

Bei einer weiteren Ausführungsform des erfindungsgemäßen Verfahrens erfolgt das Rastern des Teilchenstrahls über das Objekt mittels eines Rastermittels, welches durch eine Auswertungseinheit gesteuert wird. Vorzugsweise wird der Parameter, alternativ oder zusätzlich hierzu auch der Ort der Änderung des Parameters mittels der Auswertungseinheit bestimmt.

Bei einem bevorzugten Ausführungsbeispiel des erfindungsgemäßen Verfahrens ist der Teilchenstrahl als Elektronenstrahl ausgebildet, wobei der Elektronenstrahl über das Objekt zur Erzeugung eines Bildes gerastert wird.

Vorzugsweise ist vorgesehen, daß der Teilchenstrahl mittels eines kalten Feldemitters erzeugt wird. Hierzu ist insbesondere ein miniaturisierter kalter Feldemitter verwendbar, da diese Art von Feldemitter kleinere Spannungsänderungen zum Steuern des Teilchenstrahls (Elektronenstrahl) als ein makroskopischer Emitter benötigt. Beispielsweise wird der Teilchenstrahl mittels eines deponierten kalten Feldemitters erzeugt, wobei unter einem deponierten kalten Feldemitter ein miniaturisierter kalter Feldemitter verstanden wird, der beispielsweise mittels Elektronenstrahl-induzierter Deposition hergestellt wurde.

Bei einer weiteren Ausführungsform des erfindungsgemäßen Verfahrens wird der Teilchenstrahl zu mindestens einem Rasterpunkt geführt, an dem eine Integrationsmessung erfolgt. Beispielweise wird ein Teilchenstrahl bei der Rasterung über das Objekt zu dem Rasterpunkt geführt, an dem eine Messung mehrmals mittels des Teilchenstrahls vorgenommen wird und die auf diese Weise erhaltenen Messwerte zur Mittelwertbildung integriert werden (Pixel-Integration). Die Integrationsmessung kann aber auch für alle Rasterpunkte erfolgen, die in einer Rasterzeile angeordnet sind (Line-Integration). Alternativ hierzu kann die Integrationsmessung auch für mehrere Rasterzeilen erfolgen, die jeweils Rasterpunkte aufweisen und zu einer Einheit zusammengefaßt sind (Frame-Integration). Wenn festgestellt wird, daß an dem vorgenannten Rasterpunkt bei der Pixel-Integration eine Änderung des Parameters erfolgt ist, wird der Teilchenstrahl zu diesem Rasterpunkt wieder zurückgeführt. Wird bei der Line-Integration festgestellt, daß an einem der Rasterpunkte der Rasterzeile die Änderung des Parameters erfolgt ist, wird der Teilchenstrahl zu diesem Rasterpunkt oder einem weiteren Rasterpunkt der Rasterzeile zurückgeführt, der vor dem Rasterpunkt mit der Änderung des Parameters angeordnet ist (beispielsweise der erste Rasterpunkt der Rasterzeile, also der Rasterzeilenbeginn). Entsprechendes gilt für die Frame-Integration, wobei auch hier die Rückführung zu dem Rasterpunkt, an dem die Änderung des Parameters erfolgte, oder eine Rückführung zu einem vor diesem Rasterpunkt angeordneten weiteren Rasterpunkt des Frames (beispielsweise der Beginn einer der Rasterzeilen) vorgesehen ist. Bei allen Ausführungsbeispielen wird nach der Rückführung mit der erneuten Rasterung begonnen.

Bei einer weiteren Ausführungsform des erfindungsgemäßen Verfahrens ist eine Nachregelung der Helligkeit und des Kontrastes des erzeugten Bildes vorgesehen. Beispielsweise erfolgt die Nachregelung der Helligkeit und des Kontrastes automatisch. Bei einer Änderung des Parameters des Teilchenstrahls erfolgt die Nachregelung der Helligkeit. Durch die vorgesehene Rückführung des Teilchenstrahls an den Ort der Änderung und erneutes Abrastern werden Helligkeitssprünge weitgehend vermieden.

Das erfindungsgemäße Verfahren wird vorzugsweise in einem Teilchenstrahlgerät, beispielsweise einem Elektronenstrahlgerät verwendet, wie weiter unten noch detailliert erläutert wird.

Die Erfindung betrifft auch eine Vorrichtung zur Erzeugung eines Bildes eines Objektes mittels eines Teilchenstrahls, bei dem der Teilchenstrahl über das Objekt gerastert wird. Die erfindungsgemäße Vorrichtung ist insbesondere zur Durchführung eines Verfahrens mit mindestens einem der oben genannten Merkmale oder Merkmalskombinationen ausgebildet. Die Vorrichtung weist mindestens einen Teilchenstrahlerzeuger zur Erzeugung eines Teilchenstrahls, mindestens ein Rastermittel zum Rastern des Teilchenstrahls über das Objekt, mindestens ein Mittel zur Bestimmung eines dem Teilchenstrahl zugeordneten Parameters, mindestens ein Mittel zur Feststellung einer Änderung des Parameters, mindestens ein Mittel zur Bestimmung eines Ortes am Objekt, an dem die Änderung eines Parameters aufgetreten ist, sowie mindestens ein Mittel zur Rückführung des Teilchenstrahls an diesen Ort auf.

Bei der erfindungsgemäßen Vorrichtung wird mittels des Teilchenstrahlerzeugers der Teilchenstrahl erzeugt, welcher mittels des Rastermittels über das Objekt gerastert wird. Aufgrund des Mittels zur Bestimmung des dem Teilchenstrahl zugeordneten Parameters sowie aufgrund des Mittels zur Feststellung einer Änderung des Parameters ist es möglich, den Ort zu bestimmen, an dem sich der Parameter geändert hat. Dies erfolgt beispielsweise mit der bereits oben genannten Zeitberechnung. Anschließend wird der Teilchenstrahl an diesen Ort zurückgeführt und die Rasterung des Objektes erneut begonnen, wie bereits ebenfalls weiter oben beschrieben.

Bei der erfindungsgemäßen Vorrichtung ist es vorzugsweise vorgesehen, ein Mittel zur Änderung des Parameters auf einen Sollwert vorzusehen, das zur Änderung des Parameters - wie weiter oben beschrieben - verwendet wird.

Die erfindungsgemäße Vorrichtung weist vorzugsweise auch ein Mittel zur Einstellung eines Schwellenwertes für die Änderung des Parameters auf. Auf dieses Weise wird erreicht, daß - wie bereits weiter oben erläutert - nicht jede geringfügige Änderung des Parameters eine Rückführung des Teilchenstrahls bedingt.

Bei einer Ausführungsform der erfindungsgemäßen Vorrichtung ist das Mittel zur Rückführung des Teilchenstrahls in das Rastermittel aufgenommen. Vorzugsweise sind das Mittel zur Rückführung des Teilchenstrahls und das Rastermittel identisch ausgebildet. Sie bilden somit eine Einheit.

Ferner ist vorzugsweise vorgesehen, daß das Mittel zur Bestimmung des dem Teilchenstrahl zugeordneten Parameters als Mittel zur Bestimmung des Teilchenstrahlstroms ausgebildet ist. Beispielsweise wird somit der Emissionsstrom eines kalten Feldemitters gemessen, der als Parameter herangezogen wird.

Das Mittel zur Bestimmung des dem Teilchenstrahl zugeordneten Parameters ist zwischen dem Teilchenstrahlerzeuger und dem Objekt angeordnet. Alternativ ist vorgesehen, daß das Mittel zur Bestimmung des dem Teilchenstrahl zugeordneten Parameters in den Teilchenstrahlerzeuger integriert ist. Beispielsweise ist das Mittel zur Bestimmung des Parameters in einer Elektronenstrahlsäule zwischen einem kalten Feldemitter und einem Objekt angeordnet, wobei hier als Parameter der Emissionsstrom des kalten Feldemitters herangezogen wird.

Bei einer weiteren Ausführungsform der erfindungsgemäßen Vorrichtung ist das Mittel zur Feststellung einer Änderung des Parameters in dem Mittel zur Bestimmung des Ortes aufgenommen. Vorzugsweise ist vorgesehen, das Mittel zur Feststellung einer Änderung des Parameters und das Mittel zur Bestimmung des Ortes identisch auszubilden, es also als eine Einheit auszubilden.

Bei einer bevorzugten Ausführungsform der erfindungsgemäßen Vorrichtung ist/sind das Mittel zur Bestimmung des Parameters und/oder das Mittel zur Feststellung einer Änderung des Parameters und/oder das Mittel zur Bestimmung des Ortes am Objekt und/oder das Mittel zur Rückführung des Teilchenstrahls miteinander verbunden. Vorzugsweise ist/sind das Mittel zur Bestimmung des Parameters, das Mittel zur Feststellung einer Änderung des Parameters und/oder das Mittel zur Bestimmung des Ortes am Objekt in einer Auswertungseinheit aufgenommen.

Ferner ist es vorzugsweise vorgesehen, daß das Mittel zur Änderung des Parameters mit dem Teilchenstrahlerzeuger verbunden ist.

Bei einer weiteren Ausführungsform der Erfindung ist die Vorrichtung mit einem Mittel zur Integrationsmessung versehen, die bereits weiter oben erläutert wurde. Ferner ist vorzugsweise vorgesehen, daß die Vorrichtung ein Mittel zur Nachregelung der Helligkeit und/oder des Kontrastes des erzeugten Bildes aufweist.

Bei einer weiteren Ausführungsform der Erfindung ist der Teilchenstrahlerzeuger als Elektronenstrahlquelle ausgebildet ist. Die Vorrichtung ist somit ein Elektronenstrahlgerät, beispielsweise eines, wie nachfolgend erläutert.

Die Erfindung betrifft auch ein Elektronenstrahlgerät, insbesondere ein Rasterelektronenmikroskop, zur Erzeugung eines Bildes eines Objektes mittels eines Elektronenstrahls, bei dem der Elektronenstrahl über das Objekt gerastert wird. Das erfindungsgemäße Elektronenstrahlgerät weist mindestens eine Elektronenstrahlquelle zur Erzeugung eines Elektronenstrahls, mindestens eine Objektivlinse zur Fokussierung des Elektronenstrahls auf das Objekt, mindestens ein Rastermittel zum Rastern des Elektronenstrahls über das Objekt, mindestens ein Mittel zur Bestimmung eines dem Elektronenstrahl zugeordneten Parameters, mindestens ein Mittel zur Feststellung einer Änderung des Parameters, mindestens ein Mittel zur Bestimmung eines Ortes am Objekt, an der die Änderung des Parameters aufgetreten ist, sowie mindestens ein Mittel zur Rückführung des Elektronenstrahls an diesen Ort auf.

Ferner ist es vorgesehen, an dem erfindungsgemäßen Elektronenstrahlgerät ein Mittel zur Änderung des Parameters auf einen Sollwert hin anzuordnen.

Nachfolgend wird die Erfindung anhand von Ausführungsbeispielen mittels Figuren näher erläutert. Es zeigen
- Fig. 1: eine schematische Darstellung eines Teilchenstrahlgeräts;
- Fig. 2: eine schematische Darstellung eines Elektronenstrahlgeräts in Form eines Rasterelektronenmikroskops;
- Fig. 3a-3c: eine schematische Darstellung eines Objekts mit Rasterbildpunkten;
- Fig. 4a-4d: eine weitere schematische Darstellung eines Objekts mit Rasterbildpunkten; sowie
- Fig. 5a-5c: eine weitere schematische Darstellung eines Objekts mit Rasterbildpunkten.

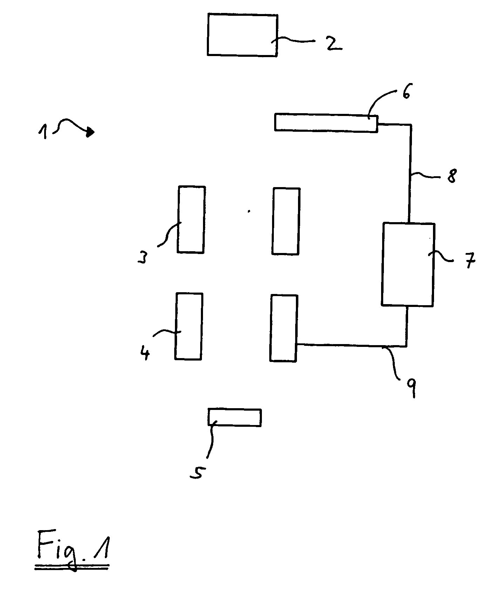

Die Erfindung wird nachfolgend zunächst allgemein anhand eines Teilchenstrahlgeräts 1 erläutert. Figur 1 zeigt die schematische Darstellung des Teilchenstrahlgeräts 1. Das Teilchenstrahlgerät 1 weist eine Strahlquelle 2 (Strahlerzeuger) auf, mit dem ein Teilchenstrahl erzeugt wird. Der Teilchenstrahl wird in eine Teilchenstrahlsäule (nicht dargestellt) eingeleitet und mittels einer Objektivlinse 3 auf ein Objekt 5 fokussiert. Um den Teilchenstrahl über das Objekt 5 zu rastern, ist ein Rastermittel 4 vorgesehen. Es wird ausdrücklich darauf hingewiesen, daß die relative Anordnung der Objektivlinse 3 und des Rastermittels 4 nur eine schematische Darstellung ist. Die tatsächliche Anordnung der Objektivlinse 3 und des Rastermittels 4 zueinander kann durchaus unterschiedlich zu der dargestellten Anordnung sein.

Der über das Objekt 5 durch das Rastermittel 4 gerasterte Teilchenstrahl tritt in Wechselwirkung mit dem Objekt 5 und erzeugt hierdurch Wechselwirkungsteilchen, die mittels eines nicht dargestellten Detektors detektiert und zur Bildgebung verwendet werden.

Das Teilchenstrahlgerät 1 weist ferner ein Teilchenstrom-Meßgerät 6 auf, welches zwischen dem Strahlerzeuger 2 und der Objektivlinse 3 angeordnet ist. Alternativ hierzu ist vorgesehen, daß das Teilchenstrom-Meßgerät in dem Strahlerzeuger 2 integriert ist. Das Teilchenstrom-Meßgerät 6 ist über eine Leitung 8 mit einer Auswertungseinheit 7 verbunden ist. Die Auswertungseinheit 7 ist darüber hinaus über eine Leitung 9 mit dem Rastermittel 4 verbunden. Mittels der Auswertungseinheit 7 ist auch ein Schwellenwert der Änderung des Teilchenstroms einstellbar. Erst wenn die Änderung des Teilchenstroms diesen Schwellenwert überschreitet, wird eine Rückführung des Teilchenstrahls veranlaßt, wie nachfolgend noch erläutert wird.

Mittels des Teilchenstrom-Meßgeräts 6 wird der Teilchenstrom des durch den Strahlerzeuger 2 erzeugten Teilchenstrahls gemessen. Der so ermittelte Teilchenstrom bzw. dessen Wert wird über die Leitung 8 an die Auswertungseinheit 7 weitergegeben. Die Auswertungseinheit 7 ist mit einem Steuerprogramm derart versehen, daß die Auswertungseinheit 7 feststellen kann, ob ein gerade gemessener Wert des Teilchenstroms sich gegenüber einem vorher gemessenen Wert des Teilchenstroms geändert hat. Hierzu ist die Auswertungseinheit 7 mit einem Mikroprozessor (nicht dargestellt) und Speicherbauteilen (nicht dargestellt) versehen, in der insbesondere das Steuerprogramm und Werte des Teilchenstroms gespeichert sind bzw. kontinuierlich gespeichert werden. Sobald die Auswertungseinheit 7 festgestellt hat, daß eine Änderung des Teilchenstroms stattgefunden hat (Schwellenwertüberschreitung), wird mittels einer Zeitberechnung der Ort des Objektes 5 ermittelt, an dem sich der Teilchenstrahl zum Zeitpunkt der Änderung des Teilchenstroms befunden hat. Zu diesem Ort wird der Teilchenstrahl dann zurückgeführt. Hierzu sendet die Auswertungseinheit 7 über die Leitung 9 entsprechende Steuersignale an das Rastermittel 4, welches den Teilchenstrahl zu dem Ort zurückführt. Anschließend wird die Rasterung des Objekts 5 von diesem Ort an wiederholt und weitergeführt. Die fehlerhafte Bildinformation, die man von bereits gerasterten Bildpunkten des Objekts 5 erhalten hat, wird gelöscht und durch die Information ersetzt, die man aufgrund der wiederholten Rasterung erhält.

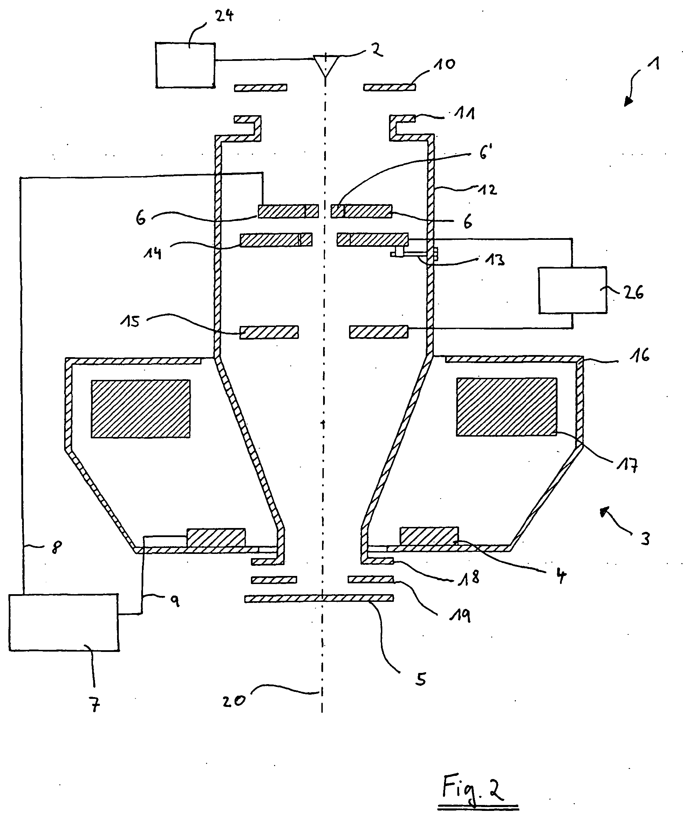

Figur 2 zeigt eine besondere Ausführungsform der erfindungsgemäßen Vorrichtung, die als Elektronenstrahlgerät in Form eines Rasterelektronenmikroskops 1 ausgebildet ist. Es weist eine Strahlquelle 2 in Form eines kalten Feldemitters, eine Extraktionselektrode 10 sowie eine Anode 11 auf, die gleichzeitig ein Ende eines Strahlführungsrohres 12 des Rasterelektronenmikroskops 1 ist. Elektronen, die aus der Strahlquelle 2 austreten, werden aufgrund einer Potentialdifferenz zwischen der Strahlquelle 2 und der Anode 11 auf Anodenpotential beschleunigt.

Das Strahlführungsrohr 12 ist durch eine Bohrung geführt, die durch Polschuhe 16 einer als Objektiv 3 wirkenden Magnetlinse eingebracht ist. In den Polschuhen 16 sind Spulen 17 angeordnet. Hinter das Strahlführungsrohr 12 ist eine elektrostatische Verzögerungseinrichtung geschaltet. Diese besteht aus einer Elektrode 19 und einer Rohrelektrode 18, die an dem einen Objekt 5 gegenüberliegenden Ende des Strahlführungsrohres 12 ausgebildet ist. Somit liegt die Rohrelektrode 18 gemeinsam mit dem Strahlführungsrohr 12 auf Anodenpotential, während die Elektrode 19 sowie das Objekt 5 auf einem gegenüber dem Anodenpotential niedrigeren Potential liegen. Auf diese Weise können die Elektronen des aus der Strahlquelle 2 tretenden Elektronenstrahls auf eine gewünschte niedrige Energie abgebremst werden, die für die Untersuchung des Objekts 5 erforderlich ist. Ferner sind Rastermittel 4 vorgesehen, durch die der Elektronenstrahl abgelenkt und über das Objekt 5 gerastert werden kann.

Zur Detektion von Sekundärelektronen oder Rückstreuelektronen, die aufgrund der Wechselwirkung des durch die Strahlquelle 2 erzeugten Elektronenstrahls mit dem Objekt 5 entstehen, ist eine Detektoranordnung mit einem ersten Detektor 14 und einem zweiten Detektor 15 im Strahlführungsrohr 12 angeordnet. Der Detektor 14 ist dabei entlang der optischen Achse 20 im Strahlführungsrohr 12 aufgrund einer Verstelleinrichtung 13 beweglich angeordnet. Der erste Detektor 14 und der zweite Detektor 15 weisen jeweils eine ringförmige Detektionsfläche auf. Es wird ausdrücklich darauf hingewiesen, daß die Erfindung nicht auf die Verwendung von zwei Detektoren eingeschränkt ist. Vielmehr kann die Erfindung stets auch nur einen einzelnen oder mehr als zwei Detektoren aufweisen. Der Detektor muß oder die Detektoren müssen auch nicht beweglich angeordnet sein. Die Detektoren 14 und 15 sind mit einer Auswerteeinheit 26 verbunden, mit welcher insbesondere Integrationsmessungen vorgenommen werden. Beispielsweise wird der Elektronenstrahl zu einem Rasterpunkt geführt, an dem eine Messung mehrmals mittels des Elektronenstrahls vorgenommen wird und wobei die auf diese Weise erhaltenen Messwerte zur Mittelwertbildung integriert werden (Pixel-Integration). Die Integrationsmessung kann aber auch für alle Rasterpunkte erfolgen, die in einer Rasterzeile angeordnet sind (Line-Integration). Alternativ hierzu kann die Integrationsmessung auch für mehrere Rasterzeilen erfolgen, die jeweils Rasterpunkte aufweisen und zu einer Einheit zusammengefaßt sind (Frame-Integration).

Das Rasterelektronenmikroskop 1 weist ferner ein Teilchenstrom-Meßgerät 6 auf, welches zur Messung des Stroms des Elektronenstrahls vorgesehen ist. Bei diesem Ausführungsbeispiel ist das Teilchenstrom-Meßgerät 6 mit einem sensitiven Bereich 6' versehen. Das Teilchenstrom-Meßgerät 6 ist über eine Leitung 8 mit einer Auswertungseinheit 7 verbunden, die wiederum über eine Leitung 9 mit dem Rastermittel 4 verbunden ist.

Das Rasterelektronenmikroskop 1 arbeitet nach dem erfindungsgemäßen Verfahren, wie es bereits für das Ausführungsbeispiel gemäß Figur 1 erläutert wurde. Insofern wird auf die weiter oben gemachten Erläuterungen verwiesen. Zusätzlich weist das Rasterelektronenmikroskop 1 ein mit der Strahlquelle 2 verbundenes Änderungsmittel 24 auf. Nach Feststellung einer Änderung des Stroms des Elektronenstrahls (Elektronenstrom) wird der Elektronenstrom auf einen Sollwert geändert. Dies gewährleistet, daß die neu erzeugten Bilder weder Helligkeitssprünge aufweisen noch zu hell bzw. zu dunkel sind. Das Änderungsmittel 24 kann selbstverständlich auch an der Ausführungsform gemäß Figur 1 ausgebildet sein.

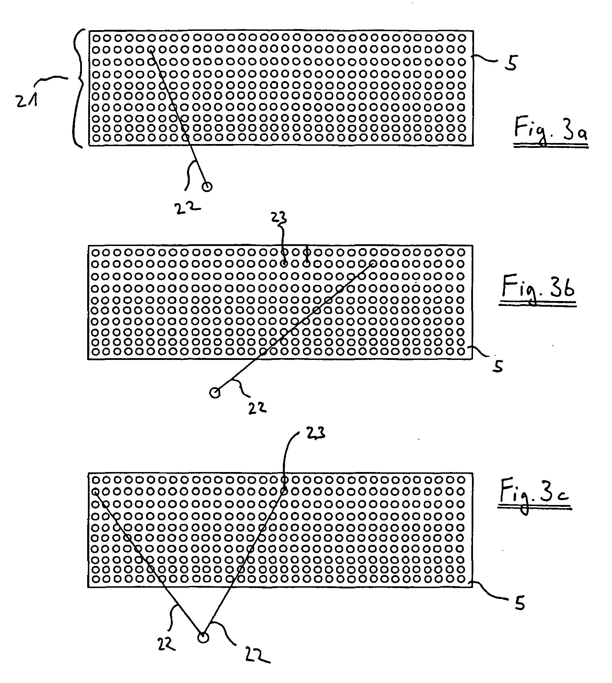

Die Figuren 3a bis 3c zeigen eine schematische Darstellung eines Objekts 5, auf dem die Rasterbildpunkte schematisch dargestellt sind, die mittels des Teilchenstrahls gemäß dem Ausführungsbeispiel nach Figur 1 oder dem Elektronenstrahl nach dem Ausführungsbeispiel gemäß Figur 2 abgerastert werden. Das Bezugszeichen 21 bezeichnet die verschiedenen Zeilen der Rasterbildpunkte auf dem Objekt 5. Der Teilchenstrahl bzw. Elektronenstrahl 22 wird derart über das Objekt 5 geführt, daß er jeden Rasterbildpunkt in jeweils einer Zeile 21 nacheinander anfährt, also "abrastert". Die Figur 3a zeigt die Stellung des Teilchenstrahls bzw. Elektronenstrahls 22 bei Abrasterung eines ersten Rasterbildpunktes einer Zeile 21, während die Figur 3b die Stellung des Teilchenstrahls bzw. Elektronenstrahls 22 bei Abrasterung eines weiteren Rasterbildpunktes derselben Zeile darstellt.

Bei Feststellung, daß der Teilchenstrom bzw. Elektronenstrom 22 sich geändert hat, wird der Ort bestimmt, an dem es zu der Änderung des Teilchenstroms bzw. Elektronenstroms 22 gekommen ist. Dieser Ort ist der Rasterbildpunkt, der in Figur 3b mit dem Bezugszeichen 23 versehen ist. Nach Bestimmung dieses Ortes wird der Teilchenstrahl bzw. Elektronenstrahl 22 durch die Rastermittel zurück zum Rasterbildpunkt 23 geführt (Figur 3c). Die Rasterung der Zeile 21, in welcher der Rasterbildpunkt 23 liegt, wird dann vom Rasterbildpunkt 23 wiederholt fortgesetzt. Alle bisherigen Informationen, die man durch Abrasterung vom Rasterbildpunkt 23 bis zu dem Rasterbildpunkt erhalten hat, an dem die Rasterung zunächst abgebrochen wurde und der Teilchenstrahl bzw. Elektronenstrahl 22 zurückgeführt wurde, werden verworfen und durch die Informationen der wiederholten bzw. neuen Abrasterung ersetzt.

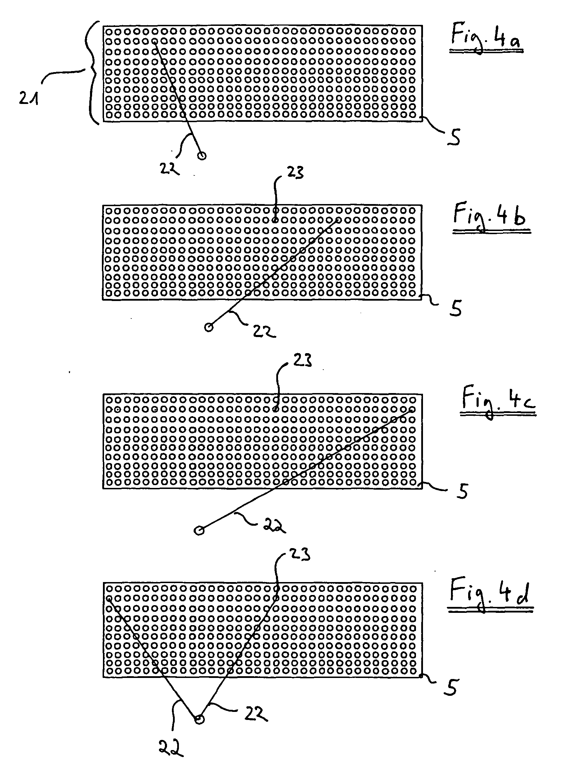

Ähnliches gilt für das Ausführungsbeispiel gemäß den Figuren 4a bis 4d. Im Unterschied zu dem Ausführungsbeispiel gemäß den Figuren 3a bis 3c wird hier die Rasterung der Zeile nach Feststellung einer Änderung des Teilchenstroms bzw. Elektronenstroms (Figur 4b) noch fortgeführt, und erst nach der vollständigen Abrasterung der Zeile 21 (Figur 4c) wird der Teilchenstrahl bzw. Elektronenstrahl 22 zu dem Rasterbildpunkt 23 zurückgeführt.

Alternativ zur Rückführung zu dem Rasterbildpunkt 23 kann bei beiden Ausführungsbeispielen vorgesehen sein, daß der Teilchenstrahl bzw. Elektronenstrahl 22 nicht zu dem Rasterbildpunkt 23, sondern zu dem Beginn der Zeile 21 geführt wird, in welcher der Rasterbildpunkt 23 liegt. Dies ist ebenfalls in Figur 3c bzw. 4d dargestellt. Bei diesem Ausführungsbeispiel wird somit die gesamte Zeile 21 nochmals neu gerastert. Die Erfindung ist somit nicht darauf eingeschränkt, daß der Teilchenstrahl nur zu dem Rasterbildpunkt (hier Rasterbildpunkt 23) zurückgeführt wird, an dem die Änderung des Parameters des Teilchenstrahls (hier der Teilchenstrahlstrom) stattgefunden hat. Vielmehr kann der Teilchenstrahl auch zu einem weiteren Rasterbildpunkt geführt werden, der vor dem Rasterbildpunkt, an dem die Änderung auftrat, angeordnet ist. Wesentlich ist nur, daß eine erneute Rasterung auch an dem Rasterbildpunkt erfolgt, an dem auch die Änderung des Parameters des Teilchenstahlstroms erfolgte.

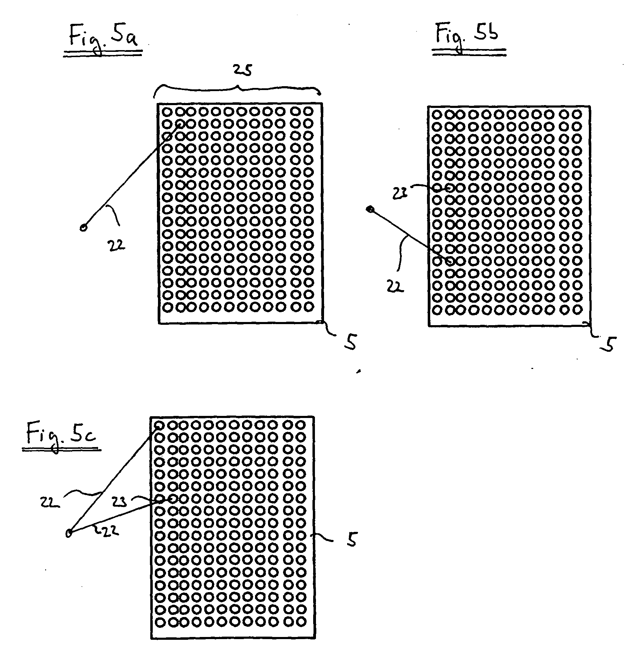

Die Figuren 5a bis 5c zeigen ein Objekt, das in Spalten 25 abgerastert wird. Im Grunde gilt hier aber genau dasselbe, wie bei den Ausführungsbeispielen gemäß den Figuren 3a bis 3c sowie 4a bis 4d.

Bei den dargestellten Ausführungsbeispielen kann insbesondere auch folgendes Verfahren angewendet werden. Wenn festgestellt wird, daß an dem Rasterbildpunkt 23 bei einer Pixel-Integration eine Änderung des Teilchenstroms bzw. Elektronenstroms erfolgt ist, wird der Teilchenstrahl bzw. Elektronenstrahl 22 zu dem Rasterpunkt 23 wieder zurückgeführt. Wird eine Line-Integration durchgeführt und festgestellt, daß an dem Rasterbildpunkt 23 die Änderung des Teilchenstroms bzw. Elektronenstroms erfolgt ist, wird der Teilchenstrahl bzw. Elektronenstrahl 22 zu dem Rasterbildpunkt 23 oder einem weiteren Rasterpunkt der Rasterzeile 21 bzw. Rasterspalte 25 zurückgeführt, der vor dem Rasterbildpunkt 23 angeordnet ist (beispielsweise der erste Rasterbildpunkt der Rasterzeile 21 bzw. Rasterspalte 25, also der Rasterzeilenbeginn oder Rasterspaltenbeginn). Entsprechendes gilt für die Frame-Integration, wobei auch hier die Rückführung zu dem Rasterbildpunkt 23 selbst oder eine Rückführung zu einem vor dem Rasterbildpunkt 23 angeordneten weiteren Rasterpunkt des Frames (beispielsweise der Beginn einer der Rasterzeilen 21 oder der Rasterspalten 25) vorgesehen ist. Bei allen Ausführungsbeispielen wird nach der Rückführung mit der erneuten Rasterung begonnen.

Wie oben bereits erwähnt, wird nach Feststellung einer Änderung des Teilchenstroms bzw. Elektronenstroms der Teilchenstrom bzw. Elektronenstrom auf einen Sollwert geändert. Dies gewährleistet, daß die neu erzeugten Bilder weder Helligkeitssprünge aufweisen noch zu hell bzw. zu dunkel sind. Dies ist insbesondere bei Verwendung einer automatischen Nachregelung der Bildhelligkeit von Vorteil. Durch die erfindungsgemäße Rückführung und erneute Rasterung ist stets eine gute Bildqualität ohne Helligkeitssprünge gewährleistet.

### Bezugszeichenliste

- 1: Elektronenstrahlgerät
- 2: Strahlquelle
- 3: Objektivlinse
- 4: Rastermittel
- 5: Objekt
- 6, 6': Teilchenstrom-Meßgerät
- 7: Auswertungseinheit
- 8: Leitung
- 9: Leitung
- 10: Extraktionselektrode
- 11: Anode
- 12: Strahlführungsrohr
- 13: Verstelleinrichtung
- 14: Detektor
- 15: Detektor
- 16: Polschuh der als Objektiv wirkenden Linse
- 17: Spule Magnetlinse
- 18: Rohrelektrode
- 19: Elektrode
- 20: Strahlachse
- 21: Zeile/Zeilen
- 22: Elektronenstrahl
- 23: Bildpunkt
- 24: Änderungeinrichtung
- 25: Spalte
- 26: Auswerteeinheit

## Patentansprüche

1. Verfahren zur Erzeugung eines Bildes eines Objektes (5) mittels eines Teilchenstrahls (22), bei dem der Teilchenstrahl (22) über das Objekt (5) gerastert wird, mit den folgenden Schritten:
- Bestimmen eines dem Teilchenstrahl (22) zugeordneten Parameters;
- Feststellen, ob eine Änderung des Parameters aufgetreten ist;
- Bestimmen eines Ortes (23) am Objekt (5), an der die Änderung des Parameters aufgetreten ist;
- Rückführen des Teilchenstrahls (22) an diesen Ort (23); sowie
- erneutes Rastern des Teilchenstrahls (22) über das Objekt (5) von diesem Ort an.

2. Verfahren nach Anspruch 1 , bei dem der Parameter über eine vorgegebene Zeit integriert und anschließend festgestellt wird, ob eine Änderung des Parameters aufgetreten ist.

3. Verfahren nach Anspruch 1 oder 2 , bei dem der Teilchenstrahl (22) jeweils von einem ersten Punkt eines vorgegebenen Musters (21) bis zu einem zweiten Punkt des vorgegebenen Musters (21) über das Objekt (5) gerastert wird, wobei nach Feststellen einer Änderung des Parameters das Rückführen des Teilchenstrahls (22) erst dann erfolgt, wenn der Teilchenstrahl (22) beim Rastern den zweiten Punkt des vorgegebenen Musters (21) erreicht.

4. Verfahren nach einem der vorangehenden Ansprüche, bei dem als Parameter ein Strom des Teilchenstrahls (22) bestimmt wird.

5. Verfahren nach einem der vorangehenden Ansprüche, bei dem das Rastern des Teilchenstrahls (22) über das Objekt (5) mittels eines Rastermittels (4) erfolgt, welches durch eine Auswertungseinheit (7) gesteuert wird und bei dem der Parameter und/oder der Ort mittels der Auswertungseinheit (7) bestimmt wird/werden.

6. Verfahren nach einem der vorangehenden Ansprüche, bei dem der Teilchenstrahl mittels eines kalten Feldemitters (2), vorzugsweise eines miniaturisierten kalten Feldemitters oder mittels eines deponierten Feldemitters erzeugt wird.

7. Verfahren nach einem der vorangehenden Ansprüche, bei dem ein Schwellenwert der Änderung des Parameters einstellbar ist.

8. Verfahren nach einem der vorangehenden Ansprüche, bei dem der Teilchenstrahl (22) zu mindestens einem Rasterpunkt (23) geführt wird, an dem eine Integrationsmessung erfolgt, und bei dem der Teilchenstrahl (22) zu dem Rasterpunkt (23) zurückgeführt wird, wenn der Rasterpunkt (23) der Ort ist, an dem die Änderung des Parameters aufgetreten ist.

9. Verfahren nach einem der vorangehenden Ansprüche, bei dem eine Nachregelung einer Bildhelligkeit und/oder eines Bildkontrastes bei der Änderung des Parameters erfolgt.

10. Verwendung eines Verfahrens nach einem der vorangehenden Ansprüche in einem Teilchenstrahlgerät (1), insbesondere einem Elektronenstrahlgerät.

11. Vorrichtung (1) zur Erzeugung eines Bildes eines Objektes (5) mittels eines Teilchenstrahls (22), bei dem der Teilchenstrahl (22) über das Objekt (5) gerastert wird, insbesondere zur Durchführung eines Verfahrens nach einem der Ansprüche 1 bis 9, mit
- mindestens einem Teilchenstrahlerzeuger (2) zur Erzeugung eines Teilchenstrahls (22);
- mindestens einem Rastermittel (4) zum Rastern des Teilchenstrahls (22) über das Objekt (5);
- mindestens einem Mittel (6) zur Bestimmung eines dem Teilchenstrahl (22) zugeordneten Parameters;
- mindestens einem Mittel (7) zur Feststellung einer Änderung des Parameters;
- mindestens einem Mittel (7) zur Bestimmung eines Ortes (23) am Objekt (5), an der die Änderung des Parameters aufgetreten ist; sowie mit
- mindestens einem Mittel (4) zur Rückführung des Teilchenstrahls (22) an diesen Ort (23).

12. Vorrichtung (1) nach Anspruch 11, wobei das Mittel zur Rückführung des Teilchenstrahls (22) in das Rastermittel (4) integriert ist und/oder wobei das Mittel zur Rückführung des Teilchenstrahls (22) und das Rastermittel (4) identisch sind.

13. Vorrichtung (1) nach Anspruch 11 oder 12 wobei das Mittel (6) zur Bestimmung des dem Teilchenstrahl (22) zugeordneten Parameters als Mittel zur Bestimmung des Teilchenstrahlstroms ausgebildet ist und/oder wobei das Mittel (7) zur Bestimmung des dem Teilchenstrahl (22) zugeordneten Parameters zwischen dem Teilchenstrahlerzeuger (2) und dem Objekt (5) angeordnet ist, oder in den Teilchenstrahlerzeuger (2) integriert ist.

14. Vorrichtung (1) nach einem der Ansprüche 11 bis 13, wobei das Mittel zur Feststellung einer Änderung des Parameters in dem Mittel (7) zur Bestimmung des Ortes (23) aufgenommen ist und/oder wobei das Mittel zur Feststellung einer Änderung des Parameters und das Mittel (7) zur Bestimmung des Ortes (23) identisch sind.

15. Vorrichtung (1) nach einem der Ansprüche 11 bis 14 wobei der Teilchenstrahlerzeuger (2) als Elektronenquelle ausgebildet ist und/oder wobei der Teilchenstrahlerzeuger (2) als kalter Feldemitter, vorzugsweise als miniaturisierter kalter Feldemitter ausgebildet ist.

16. Elektronenstrahlgerät (1), insbesondere ein Rasterelektronenmikroskop, zur Erzeugung eines Bildes eines Objektes (5) mittels eines Elektronenstrahls (22), bei dem der Elektronenstrahl (22) über das Objekt (5) gerastert wird, insbesondere zur Durchführung eines Verfahrens nach einem der Ansprüche 1 bis 9, mit
- mindestens einer Elektronenstrahlquelle (2) zur Erzeugung eines Elektronenstrahls (22);
- mindestens einer Objektivlinse (3) zur Fokussierung des Elektronenstrahls (22) auf das Objekt (5);
- mindestens einem Rastermittel (4) zum Rastern des Elektronenstrahls (22) über das Objekt (5);
- mindestens einem Mittel (6) zur Bestimmung eines dem Elektronenstrahl zugeordneten Parameters;
- mindestens einem Mittel (7) zur Feststellung einer Änderung des Parameters;
- mindestens einem Mittel (7) zur Bestimmung eines Ortes (23) am Objekt (5), an der die Änderung des Parameters aufgetreten ist; sowie mit
- mindestens einem Mittel (4) zur Rückführung des Elektronenstrahls (22) an diesen Ort (23).

## Claims

1. Method for producing an image of an object (5) using a particle beam (22), wherein the particle beam (22) is scanned over the object (5), comprising the following steps:
- determining a parameter that Is assigned to the particle beam (22);
- determining whether a change has occurred in the parameter;
- determining a location (23) on the object (5) at which the change has occurred in the parameter;
- returning the particle beam (22) to this location (23); and
- rescanning the particle beam (22) over the object (5) from this location onward.

2. Method according to claim 1, wherein the parameter Is integrated over a specified period of time, and It is then determined whether a change has occurred In the parameter.

3. Method according to claim 1 or claim 2, wherein the particle beam (22) Is scanned over the object (5) from a first point of a specified pattern (21) to a second point of the specified pattern (21), wherein after determining that a change has occurred In the parameter, the particle beam (22) is not returned until the particle beam (22) has reached the second point of the specified pattern (21) during the scanning process.

4. Method according to one of the preceding claims, wherein a current of the particle beam (22) is determined as the parameter.

5. Method according to one of the preceding claims, wherein the particle beam (22) Is scanned over the object (5) using a scanning means (4), which is controlled by an evaluation unit (7), and wherein the parameter and/or the location is/are determined using the evaluation unit (7).

6. Method according to one of the preceding claims, wherein the particle beam is produced using a cold field emitter (2), preferably a miniaturized cold field emitter, or using a deposited field emitter.

7. Method according to one of the preceding claims, wherein a threshold value of the change In the parameter may be set.

8. Method according to one of the preceding claims, wherein the particle beam (22) Is guided to at least one scanning point (23), at which an integrating measurement is carried out, and wherein the particle beam (22) is returned to the scanning point (23) If the scanning point (23) is the location at which the change occurred in the parameter.

9. Method according to one of the preceding claims, wherein, when a change has occurred in the parameter, an image brightness and/or an Image contrast are/is readjusted.

10. Use of a method according to one of the preceding claims in a particle beam device (1), in particular in an electron beam device.

11. Device (1) for producing an image of an object (5) using a particle beam (22), wherein the particle beam (22) is scanned over the object (5), In particular to perform a method according to one of the claims 1 through 9, including:
- at least one particle beam generator (2) for producing a particle beam (22);
- at least one scanning means (4) for scanning the particle beam (22) over the object (5);
- at least one means (6) for determining a parameter that is assigned to the particle beam (22);
- at least one means (7) for determining that a change has occurred in the parameter;
- at least one means (7) for determining a location (23) on the object (5) at which the change occurred in the parameter, and including
- at least one means (4) for returning the particle beam (22) to this location (23).

12. Device (1) according to claim 11,
wherein the means for returning the particle beam (22) is integrated In the scanning means (4) and/or wherein the means for returning the particle beam (22) and the scanning means (4) are identical.

13. Device (1) according to claims 11 or 12, wherein the means (6) for determining the parameter assigned to the particle beam (22) is designed as a means for determining the particle beam current and/or wherein the means (7) for determining the parameter assigned to the particle beam (22) is located between the particle beam generator (2) and the object (5), or is integrated in the particle beam generator (2).

14. Device (1) according to one of the claims 11 through 13, wherein the means for determining that a change has occurred in the parameter is accommodated in the means (7) for determining the location (23) and/or wherein the means for determining that a change has occurred In the parameter and the means (7) for determining the location (23) are identical.

15. Device (1) according to one of the claims 11 through 14, wherein the particle beam generator (2) is designed as an electron source and/or wherein the particle beam generator (2) is designed as a cold field emitter, preferably as a miniaturized cold field emitter.

16. Electron beam device (1), in particular a scanning electron microscope, for producing an image of an object (5) using an electron beam (22), wherein the electron beam (22) is scanned over the object (5), in particular to perform a method according to one of the claims 1 through 9, including:
- at least one electron beam generator (2) for producing an electron beam (22);
- at least one objective lens (3) for focusing the electron beam (22) on the object (5);
- at least one scanning means (4) for scanning the electron beam (22) over the object (5);
- at least one means (6) for determining a parameter that is assigned to the electron beam;
- at least one means (7) for determining that a change has occurred In the parameter;
- at least one means (7) for determining a location (23) on the object (5) at which the change has occurred in the parameter; and including
- at least one means (4) for returning the electron beam (22) to this location (23).

## Revendications

1. Procédé de génération d'une Image d'un objet (5) au moyen d'un faisceau de particules (22), dans lequel le faisceau de particules (22) effectue un balayage de l'objet (5), comprenant les étapes suivantes consistant à :
- déterminer un paramètre associé au faisceau de particules (22) ;
- constater si une modification du paramètre est intervenue ;
- déterminer, au niveau de l'objet (5), un emplacement (23) au niveau duquel la modification du paramètre est intervenue ;
- rediriger le faisceau de particules (22) au niveau de cet emplacement (23) ; ainsi que
- effectuer à nouveau un balayage de l'objet (5) par le faisceau de particules (22) à partir de cet emplacement.

2. Procédé selon la revendication 1, dans lequel le paramètre est intégré sur une période spécifiée et il est ensuite constaté si une modification du paramètre est Intervenue.

3. Procédé selon la revendication 1 ou 2, dans lequel le faisceau de particules (22) effectue un balayage de l'objet (5) respectivement à partir d'un premier point d'un échantillon spécifié (21) jusqu'à un second point de l'échantillon spécifié (21), la redirection du faisceau de particules (22), après constatation d'une modification du paramètre, n'ayant ensuite lieu que lorsque le faisceau de particules (22) atteint le second point de l'échantillon spécifié (21) lors du balayage.

4. Procédé selon l'une quelconque des revendications précédentes, dans lequel un flux du faisceau de particules (22) est déterminé en tant que paramètre.

5. Procédé selon l'une quelconque des revendications précédentes, dans lequel le balayage de l'objet (5) par le faisceau de particules (22) a lieu au moyen d'un moyen de balayage (4), qui est commandé par une unité d'évaluation (7) et dans lequel le paramètre et/ou l'emplacement est/sont déterminé(s) au moyen de l'unité d'évaluation (7).

6. Procédé selon l'une quelconque des revendications précédentes, dans lequel le faisceau de particules est généré au moyen d'un émetteur de champ (2) froid, de préférence un émetteur de champ froid miniaturisé ou au moyen d'un émetteur de champ créé par dépôt.

7. Procédé selon l'une quelconque des revendications précédentes, dans lequel une valeur de seuil de la modification du paramètre peut être ajustée.

8. Procédé selon l'une quelconque des revendications précédentes, dans lequel le faisceau de particules (22) est dirigé vers au moins un point de balayage (23), au niveau duquel a lieu une mesure d'intégration, et dans lequel le faisceau de particules (22) est redirigé vers le point de balayage (23), lorsque le point de balayage (23) est l'emplacement au niveau duquel la modification du paramètre est Intervenue.

9. Procédé selon l'une quelconque des revendications précédentes, dans lequel un réajustement d'une luminosité d'image et/ou d'un contraste d'image a lieu lors de la modification du paramètre.

10. Utilisation d'un procédé selon l'une quelconque des revendications précédentes dans un appareil à faisceau de particules (1), en particulier un appareil à faisceau d'électrons.

11. Dispositif (1) de génération d'une image d'un objet (5) au moyen d'un faisceau de particules (22), dans lequel le faisceau de particules (22) effectue un balayage de l'objet (5), en particulier pour la mise en oeuvre d'un procédé selon l'une quelconque des revendications 1 à 9, avec
- au moins un générateur de faisceau de particules (2) pour générer un faisceau de particules (22) ;
- au moins un moyen de balayage (4) pour que le faisceau de particules (22) effectue un balayage de l'objet (5) ;
- au moins un moyen (6) pour déterminer un paramètre associé au faisceau de particules (22) ;
- au moins un moyen (7) pour constater une modification du paramètre ;
- au moins un moyen (7), pour déterminer, au niveau de l'objet (5), un emplacement (23) au niveau duquel la modification du paramètre est intervenue ; ainsi qu'avec
- au moins un moyen (4) pour rediriger le faisceau de particules (22) au niveau de cet emplacement (23).

12. Dispositif (1) selon la revendication 11, dans lequel le moyen de redirection du faisceau de particules (22) est intégré dans le moyen de balayage (4) et/ou dans lequel le moyen de redlrection du faisceau de particules (22) et le moyen de balayage (4) sont identiques.

13. Dispositif (1) selon la revendication 11 ou 12, dans lequel le moyen (6) de détermination du paramètre associé au faisceau de particules (22) est réalisé en tant que moyen de détermination du flux de faisceau de particules et/ou dans lequel le moyen (7) de détermination du paramètre associé au faisceau de particules (22) est agencé entre le générateur de faisceau de particules (2) et l'objet (5), ou est intégré dans le générateur de faisceau de particules (2).

14. Dispositif (1) selon l'une quelconque des revendications 11 à 13, dans lequel le moyen de constatation d'une modification du paramètre est logé dans le moyen (7) de détermination de l'emplacement (23) et/ou dans lequel le moyen de constatation d'une modification du paramètre et le moyen (7) de détermination de l'emplacement (23) sont identiques.

15. Dispositif (1) selon l'une quelconque des revendications 11 à 14, dans lequel le générateur de faisceau de particules (2) est réalisé en tant que source d'électron et/ou dans lequel le générateur de faisceau de particules (2) est réalisé en tant qu'émetteur de champ froid, de préférence en tant qu'émetteur de champ froid miniaturisé.

16. Appareil à faisceau d'électrons (1), en particulier un microscope électronique à balayage, pour générer une Image d'un objet (5) au moyen d'un faisceau d'électrons (22), dans lequel on effectue un balayage de l'objet (5) par le faisceau d'électrons (22), en particulier pour la mise en oeuvre d'un procédé selon l'une quelconque des revendications 1 à 9, avec
- au moins une source de faisceau d'électrons (2) pour générer un faisceau d'électrons (22) ;
- au moins une lentille d'objectif (3) pour une focalisation du faisceau d'électrons (22) sur l'objet (5) ;
- au moins un moyen de balayage (4) pour effectuer un balayage de l'objet (5) par le faisceau d'électrons (22) ;
- au moins un moyen (6) de détermination d'un paramètre associé au faisceau d'électrons ;
- au moins un moyen (7) de constatation d'une modification du paramètre ;
- au moins un moyen (7) de détermination, au niveau de l'objet (5), d'un emplacement (23) au niveau duquel la modification du paramètre est Intervenue ; ainsi qu'avec
- au moins un moyen (4) de redirection du faisceau d'électrons (22) au niveau de cet emplacement (23).
